# EUROPEAN PATENT APPLICATION

(11) **EP 0 794 460 A2**
(43) Date of publication of application: **10.09.1997**
(21) Application number: 97301211.5
(22) Date of filing: 25.02.1997
(51) Int. Cl.: G03F 7/09

(54) **A process for device fabrication and an anti-reflective coating for use therein**

(30) Priority: 07.03.1996 US 611595
(71) Applicant: LUCENT TECHNOLOGIES INC., Murray Hill, New Jersey 07974-0636 (US)
(72) Inventor: Cirelli, Raymond Andrew, Hillsborough, New Jersey 08876 (US); Weber, Gary Robert, Whitehouse Station, New Jersey 08889 (US)
(74) Representative: Johnston, Kenneth Graham

(57) **Abstract**

The present invention is directed to a process for device fabrication. An anti-reflection coating is formed over a topographic substrate surface before an energy sensitive resist is applied thereover. The anti-reflective coating has at least two indices of refraction, a first one at the interface between the anti-reflection coating and the overlying resist, and a second one at the interface between the anti-reflection coating and the underlying substrate. The anti-reflective coating is a silicon-containing oxide and the index of refraction of the coating is changed by altering the amount of silicon in the film relative to the amount of oxygen in the film. It is advantageous if the first index of refraction matches the index of refraction of the resist overlying the substrate. It is advantageous if the thickness and the index of refraction of the film is selected to absorb substantially all of the radiation incident on the anti-reflection coating when the resist is patternwise exposed to radiation.

## Description

### Background of the Invention

### Technical Background

This invention relates to a lithographic process for device fabrication in which an anti-reflection coating is used to reduce undesirable reflections in an energy-sensitive material formed over a topographic substrate when that energy sensitive material is exposed to radiation.

### Art Background

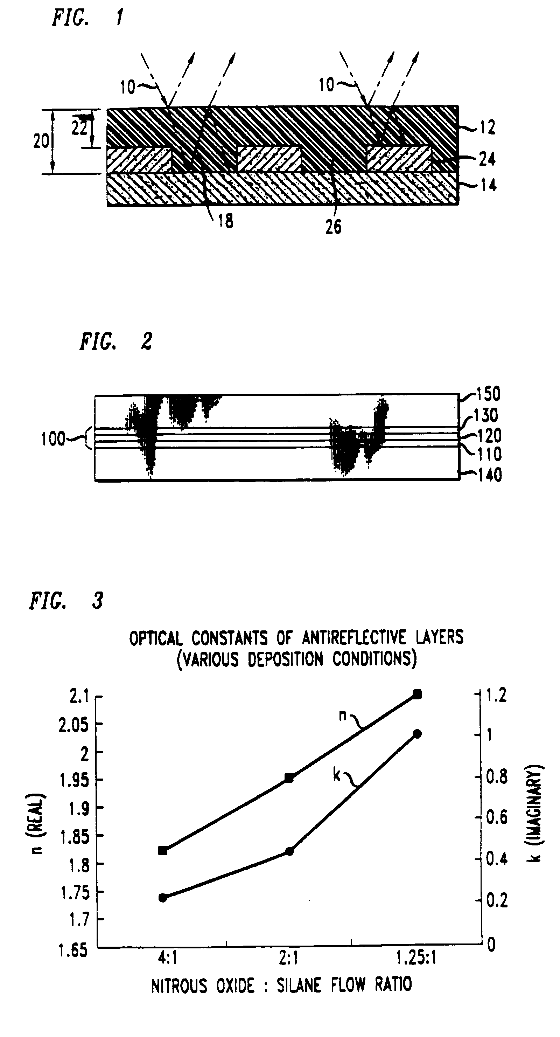

In optical lithography, one of the greatest challenges is to accurately control the printed dimensions of the features introduced in an energy sensitive resist material formed over substrate surfaces with varying topography and varying reflectivity. The difficulty in critical dimension control stems from the fact that some of the patterned radiation is reflected from the interfaces between the energy sensitive resist material and the atmosphere and the energy sensitive resist material and the underlying substrate. The problem of reflection at the interface between the substrate and the resist is illustrated schematically in FIG 1. Radiation 10, which has previously been patterned by transmission through a mask (not shown), is incident upon an energy sensitive material 12 overlying a substrate 14. An image of the pattern defined by the mask is thereby introduced into the energy sensitive material. A portion of the incident radiation is absorbed by the energy sensitive resist. The portion that is not absorbed, however, is reflected back from the interface between the energy sensitive material and the substrate into the energy sensitive material. As shown in FIG. 1, the exposing radiation 10 is not completely absorbed by the energy-sensitive resist material 12. The unabsorbed radiation, is reflected as ray 18 from the interface between the energy-sensitive material 12 and the underlying substrate 14 and back into the energy sensitive material 12. A portion of the reflected radiation 18 is again reflected at the top surface of the energy sensitive resist material 12.

These reflected rays 18 interfere either constructively or destructively with the incident radiation 10 as well as with each other. This interference affects the total amount of energy available for exposing the energy sensitive material. Since the amount of energy absorbed by the resist material is a function of thickness, it follows that the amount of interference is also a function of resist thickness. The thickness of a resist layer varies when formed over a topographic, i.e., non-planar, substrate surface. As shown in FIG. 1, resist thickness 20 is thicker than resist thickness 22. When exposing radiation is reflected from the resist layer/substrate surface interface, the amount of radiation available for exposing the resist material varies as a function of resist film thickness which results in what is commonly referred to as the swing effect. The amount of energy introduced into the resist overlying features 24 is different from the amount of energy introduced into the resist overlying the spaces 26 between these features because the amount of reflected radiation is a function of resist thickness. This variation in exposure results in developed features that have variations in dimensions. Whether the interference is constructive or destructive depends upon the resist thickess due to bulk absorption and standing wave affects as explained in Cuthbert, J. D., et al., "Optical Projection Printing," Solid State Technology, Vol. 20, p. 59 (1977).

Different solutions have been proposed to the problem of reducing or eliminating the reflections of the exposing radiation from the resist material/substrate interface. One proposed method incorporates a dye into the energy sensitive material. The dye is selected so that it absorbs radiation at the wavelength or wavelengths of the exposing radiation. This attenuates the intensity of the radiation as it passes through the resist and reduces the intensity of the reflected radiation. The problem with this solution is that it requires over-exposure of the top portion of the energy-sensitive material in order to ensure that the bottom portion is adequately exposed. This "exposure gradient" causes a slope in the resist profile which increases with increasing dye concentration.

A second solution is the use of an anti-reflection coating that is applied over the energy sensitive material. Lyons, C., et al., "TAR processing for CD control in I-line and 248 nm lithography," SPIE, Vol. 1927, p. 759 (1993) propose using a dyed photoresist with a top anti-reflection coating (TAR) to control the dimensions of the printed features by reducing the amount of radiation that is reflected from the energy-sensitive resist material/TAR interface. The TAR shifts the phase of the reflected radiation by one-half wavelength to reduce the variation in reflectivity from the resist/TAR interface. However, this solution requires very precise control of the TAR thickness and refractive index in order to achieve the desired result.

A third proposed solution is the use of an anti-reflection coating below the resist. This is referred to as a bottom anti-reflection coating (BARC). Theoretically, a BARC eliminates all reflection at the substrate interface by absorbing the radiation that is transmitted through the resist layer. As noted in Ogawa, T., "SiOₓN_{y}, high performance anti-reflective layer for current and future optical lithography," SPIE, Vol. 2197, pp. 722-732 (1994) the composition and thickness of the anti-reflective coating must be tightly controlled in order to obtain the desired cancellation in reflected light. Furthermore, the composition and thickness of the anti-reflective coating must be tailored to accommodate the underlying substrate. Therefore, the BARC described in Ogawa et al. is not universally adaptable to a variety of substrates and resists.

Consequently, although anti-reflective coatings have proven to be useful in lithographic processes to reduce the amount of unwanted reflections in the patternwise exposure of the energy-sensitive resist material, there is a need for these anti-reflective coatings to be more adaptable to use with different energy sensitive resist materials and with different substrate materials.

### Summary of the Invention

The present invention is directed to a process for device fabrication. In the process, an anti-reflection coating is formed over a substrate. Examples of suitable substrates include silicon wafers and silicon wafers with additional layers of material (e.g. SiO₂) used to form devices on the wafer. Typically, the surface of the substrate will be topographic (i.e. non-planar). A layer of energy-sensitive resist material is then applied over the anti-reflection coating. The anti-reflection coating has a first index of refraction at the interface of the anti-reflection coating and the energy-sensitive material (the top interface hereinafter). The anti-reflection coating has a second index of refraction at the interface of the anti-reflection coating and the underlying substrate (the bottom interface hereinafter). A pattern is printed in the energy-sensitive resist material via a patternwise exposure to radiation. The pattern is developed in the energy-sensitive resist material, and the pattern is transferred into the underlying substrate. The expedients used to expose the energy-sensitive resist material, to develop the pattern, and to transfer the pattern into the underlying substrate are conventional expedients well-known to one skilled in the art.

The anti-reflection coating of the present invention has at least two indices of refraction as previously described. In one embodiment of the present invention, the anti-reflection coating has an index gradient throughout the layer that changes from a first value at the top interface to a second value at the bottom interface. In another embodiment, the anti-reflective coating has at least two layers, each layer having a different index of refraction. The degree of difference in the index of refraction between the layers in the anti-reflection coating is selected so that the reflected intensity at the interface between the layers is small. In this regard, it is advantageous if the difference in the refractive index between two adjacent layers is such that the amount of light reflected due to the index change is less than about 10 percent of the incident light.

The refractive index of the anti-reflection layer is varied by varying the composition of the layer. In one embodiment of the invention, the anti-reflection layer is made of a silicon-containing oxide. The refractive index of the material is varied by varying the amount of silicon in the film relative to the amount of oxygen in the film. In the embodiment where the anti-reflective coating is a single layer, the flow rates of the gaseous reactants used to form the silicon-containing oxide film are varied as the layer is formed to produce a layer in which the refractive index varies as a function of thickness. In the embodiment wherein the anti-reflective coating has a plurality of layers, the deposition conditions for each layer are different from the deposition conditions of the other layers to obtain a multilayer structure in which the composition of each layer is sufficiently different so that each layer has a different index of refraction.

The anti-reflection coating of the present invention is index matched at the top interface with the overlying resist to reduce the amount to which radiation is reflected at that interface. In the context of the present invention, "index matched" means that the refractive index of the anti-reflective coating at the top interface is sufficiently close to the refractive index of the overlying resist layer so that any reflection that occurs at the top interface is within process tolerances. Again, it is advantageous if the difference in the refractive index between two adjacent layers is such that the amount of light reflected due to the index change is less than about 10 percent of the incident light. In the embodiment in which the anti-reflective coating has multiple layers, it is advantageous if the difference in the refractive index between any two adjacent layers is within this limit. The thickness of the layer or layers of the anti-reflective coating are selected so that the exposing energy is substantially completely absorbed as it is transmitted through the anti-reflective coating. Consequently, the amount of radiation reflected at the bottom of the interface is limited to the amount of radiation that can be reflected without adverse lithographic consequences.

The layers containing silicon and oxygen are formed by conventional means such as by plasma deposition. Silane and nitrous oxide gases are introduced into a chamber with a substrate therein. The flow rate of silane gas relative to the nitrous oxide determines the amount of silicon relative to the amount of oxygen in the layer. For example, a first layer silicon-containing oxide is formed on the substrate by flowing silane gas at 200 sccm and nitrous oxide at 250 sccm into the chamber. The next layer is formed on the first layer by flowing the silane gas into the chamber at 200 sccm and the nitrous oxide at 600 sccm. By varying the flow rates in the above-described manner, the amount of silicon relative to the amount of oxygen in the anti-reflective coating is varied. By varying the composition of the anti-reflection coating in this manner, the refractive index of the anti-reflection layer is also varied.

The silicon-containing ARC layer or layers also has an etch resistance that permits the ARC to function as an etch mask during subsequent pattern transfer into the underlying substrate.

It is contemplated that the multilayer embodiment of the anti-reflective coating of the present invention can have more than two layers. If more than two layers are present, each layer has a refractive index that is different from the other layers in the coating.

### Brief Description of the Drawings

FIG.1 is an illustration of how a typical lithographic exposure gives rise to unwanted reflections that expose portions of the energy sensitive resist material to radiation that are not desired to be so exposed.

FIG. 2 is an illustration of the anti-reflection coating of the present invention.

FIG. 3 illustrates the relationship between the flow rates of the reactant gases used to form the anti-reflection coating of the present invention and the real and imaginary indices of the coating.

FIG. 4A is a photograph of lines formed over a topographic substrate without the anti-reflective coating of the present invention.

FIG. 4B is a photograph of features formed over a topographic substrate with the anti-reflective coating of the present invention formed thereover.

### Detailed Description

The present invention is directed to an anti-reflective coating (ARC) for use in lithographic processes for device fabrication. The anti-reflective coating of the present invention has at least two different indices of refraction. The first index of refraction is at the top interface (previously defined as the interface between the ARC and the overlying layer of energy sensitive resist material). The second index of refraction is in a plane intermediate between the top interface and the bottom interface (previously defined as the interface between the ARC and the substrate underlying the ARC) or at the bottom interface.

In the process of the present invention, the energy transmitted into the ARC is absorbed by the ARC, so that no adverse lithographic consequences result from the reflection of radiation at the bottom interface of the ARC layer. Consequently, the ARC layer is made of a material that absorbs radiation at the wavelength of the exposing radiation. It is advantageous if the material is a silicon-containing oxide, wherein the amount of silicon is greater than the stoichiometric amount relative to the amount of oxide in the film. Thus the ARC layer of the present invention prevents the reflection of any significant energy from the substrate surface, back into the energy sensitive resist material. In the context of the present invention "significant energy" means energy that is sufficient to cause adverse lithographic consequences.

The ARC of the present invention is either a single layer with a first index of refraction and a second index of refraction as previously described, or a plurality of layers, each layer having a different index of refraction. It is advantageous if the index of refraction at the top interface is close to the index of refraction of the overlying photoresist layer. In the context of the present invention, it is advantageous if the refractive index is within about 10 percent of the index of refraction of the overlying photoresist. The refractive index referred to above is the real portion of the refractive index at the wavelength of the incident radiation.

There is also an imaginary portion of the refractive index. The imaginary portion of the refractive index is related to the absorption of the material at that wavelength. The imaginary portion of the refractive index is related to the absorption coefficient by the equation: k=(λ/4π)α, where k is the value of the imaginary part of the index of refraction, λ is the exposing wavelength, α is the absorption coefficient of the material, and π is the constant pi. Since the index of refraction of the material cannot be varied independently from the absorption of the material, the ARC also has a different absorption at the top interface than at the bottom interface. When referring to both portions of the refractive index herein the following expression is used: x + iy. Unless otherwise specified, the term refractive index refers to the real component of the refractive index.

The ARC of the present invention is tailored to absorb the radiation incident thereon and not reflect a significant amount of the radiation incident thereon. In the context of the present invention, a significant amount of reflected radiation is an amount that results in adverse lithographic consequences. Therefore, it is advantageous if the index of refraction changes gradually to avoid excessive reflection at the place or places in the ARC where the index changes. FIG. 2 illustrates the embodiment of the present invention wherein the ARC has multiple layers of non-stoichiometric silicon oxide. In the illustrated embodiment the ARC 100 has three layers, 110, 120 and 130. The ARC is formed over a substrate 140. Typically, the surface of the substrate is non-planar, i.e. topographic, because the ARC is used is to correct for problems associated with resist layers formed over topography. However, topography is not illustrated on the surface of the substrate depicted in FIG. 2. A layer of energy sensitive resist material 150 is formed over the ARC.

Although the invention is contemplated as useful in conjunction with a variety of energy sensitive resist materials, it is advantageous if the resist material is a conventional deep-ultraviolet (248 nm) resist, because these resist materials are easily index matched with silicon-containing oxide materials. For example, in the tri-layer ARC illustrated in FIG. 2, the resist layer 150 is a conventional deep UV resist such as ARCH 2® which is obtained commercially from Olin Cieby Giegy. ARCH 2® is a registered trademark of Olin Cieby Giegy. In this embodiment, an ARC with a top layer 130 that has a refractive index of about 1.82 + i0.23 is contemplated as suitable. Such a layer 130 is formed using conventional apparatus and conditions for forming a silicon-containing oxide film. The desired index is obtained by controlling the flow rate of the nitrous oxide relative to the silane to about 4:1.

Since the ARC of the present invention is intended to absorb substantially all of the radiation incident thereon, it must absorb at the relevant wavelength and have a sufficient thickness to attenuate the incident radiation. In the present embodiment the thickness of the top layer 130 is selected to be 25 nm. One skilled in the art will appreciate that the thickness of the ARC layer or layers will vary depending upon the absorption of the ARC layer material at the wavelength of the incident radiation. The thickness of the ARC layer or layers, while largely a matter of design choice, is selected based upon the amount of reflectivity which can be tolerated in the lithographic process and the contstraints imposed by process integration.

In order to achieve the desired absorbance within these thickness parameters, the intermediate ARC layer 120 has a refractive index of 1.95 + i 0.45. The real component of the refractive index is sufficiently close to the refractive index of the layer 130 so that the amount of reflection at the interface of layers 120 and 130 is within lithographic tolerances. The absorption of layer 120 is greater than the absorption of layer 130, so that layer 120 absorbs more of the incident radiation through its thickness. In this embodiment the thickness of layer 120 is also selected to be 25 nm. Layer 120 is formed using a flow rate ratio of nitrous oxide to silane of about 2:1.

The bottom ARC layer 110 has a refractive index of 2.1 + i 1.01. The real component of the refractive index is sufficiently close to the refractive index of the layer 120 so that the amount of reflection at the interface of layers 120 and 110 is within lithographic tolerances. The absorption of layer 110 is greater than the absorption of layer 120, so that layer 110 absorbs more of the incident radiation through its thickness. In this embodiment the thickness of layer 110 is selected to be 30 nm in order to obtain the desired degree of absorption. Layer 110 is formed using a flow rate ratio of nitrous oxide to silane of about 1.25:1.

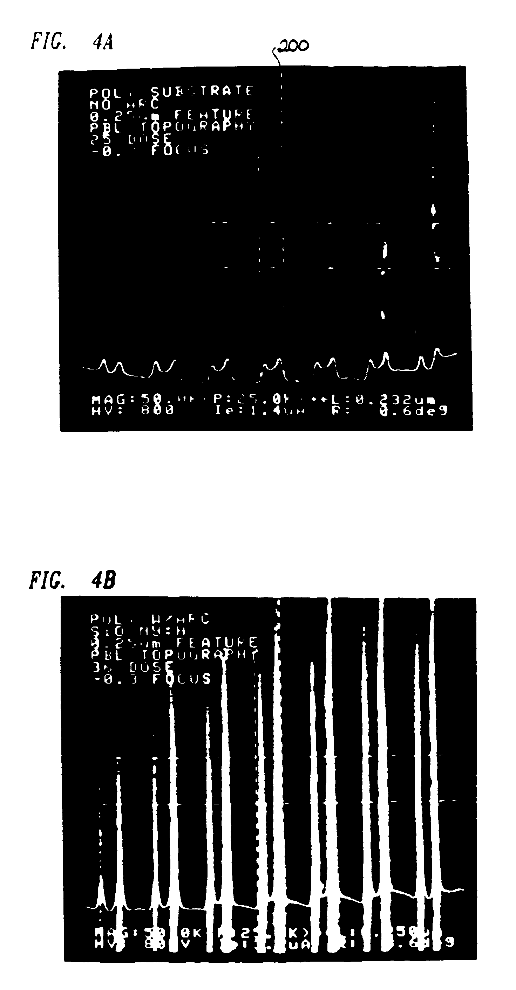

The index of refraction of the material is varied by varying the composition of the ARC. For example, if the ARC layers are formed by plasma deposition using silane gas and nitrous oxide, the composition is varied by varying the flow rates of the silane gas relative to the nitrous oxide gas. Since the composition of the film is a function of the flow rates of the nitrous oxide and silane into the chamber, it follows that the refractive index (both the real and imaginary components) is a function of the flow rate of these reactants. This is illustrated in FIG. 3, which is a graph of both the real and imaginary components of the refractive index as a function of the ratio of the flow rates of nitrous oxide and silane. FIG. 3 demonstrates that both portions of the refractive index increase with increasing silicon content in the silicon-containing oxide films. For example, a film with a refractive index of about 1.82 + i0.23 is obtained when the nitrous oxide/silane flow rate ratio is about 4:1. A film with a refractive index of about 1.95 + i0.45 was obtained with a nitrous oxide/silane flow rate ratio of about 2:1. A film with a refractive index of about 2.1 + i1.01 was obtained with a nitrous oxide/silane flow rate ratio of about 1.25:1. As illustrated in the following examples, if layers of plasma deposited silicon oxide are formed using different relative flow rates of silane gas and nitrous oxide to form each successive layer, the resulting layers have different indices of refraction from each other.

### Example 1

A 200 nm thick layer of silicon dioxide was formed on a 5-inch silicon wafer using conventional expedients well known to one skilled in the art. A layer of photoresist was formed over the oxide layer and then patternwise exposed using a reticle with a grating that defines 800 nm lines and spaces. The pattern was developed using conventional expedients and the pattern was then transferred into the underlying oxide layer, thereby forming a pattern of 800 nm lines and spaces with a step height of 200 nm on the substrate surface. A 200 nm-thick layer of polysilicon was then formed on the patterned wafer, again using conventional expedients.

The wafers were then divided into separate lots A and B. A trilayer ARC was formed on the lot B wafers by placing each wafer individually in a chamber equipped with supply lines for silane gas and for nitrous oxide. A first layer of silicon-containing oxide was formed on the substrate by introducing the silane and nitrous oxide into the chamber of an Applied Materials Model 5000 plasma deposition apparatus at respective flow rates of 200 sccm and 250 sccm. The chamber pressure was 2.5 torr and the power was 125 Watts. The wafer temperature was about 410°C. The plasma susceptor was placed about 350 mils from the wafer. Under these conditions, a 350 Å-thick layer was formed on the substrate in about 2 seconds. The composition of the layer, as determined from Rutherford backscattering, was SiO_{0.54}. The index of refraction of this layer was determined to be 2.127 (real component) + i1.015 (imaginary component). All of the refractive indices reported in this example were measured using ellipsometry at 256 nm.

A second layer was then formed on the layer described above under the same conditions, except the flow rate of the nitrous oxide was increased to 600 sccm. The thickness of the resulting layer was about 250 Å. The composition of the resulting layer, determined as described above, was SiO_{0.79}. The deposition time was 1.8 seconds and the index of refraction of the resulting layer was 1.93 + i0.433.

A third layer was then formed on the layer described above under the same conditions, except the flow rate of the nitrous oxide was increased to 800 sccm for 1.7 seconds. The resulting layer had a thickness of about 300 Å and an index of refraction of 1.852 + i0.265.

Wafers from lots A (no ARC layer) and B (ARC layer formed thereon) were then coated with a 70 nm thick layer of ARCH II® photoresist. The photoresist was then exposed to patterned 248 nm radiation using a deep UV stepper (GCA Model XLS) with a 0.53 numerical aperture. The radiation was patterned using a mask defining 250 nm lines and spaces and isolated features aligned perpendicular to the topography. The wafers were then baked at 130°C and the patterns were developed using a solution of tetra methyl ammonium hydroxide and deionized water.

Photographs of the developed patterns were then obtained. FIG. 4A is a photograph of the lines developed on a wafer in lot A. In FIG. 4A the lines 200 have a variable width. The lines have one width where they overly the raised portions of the underlying topography and another width where they do not overly the raised portions of the underlying topography. This indicates that a different amount of radiation was introduced into this portion of the resist than in the other portions of the exposed resist. No such width variations are observed in FIG. 4B, which is a photograph of the lines developed on a wafer in lot B. These figures demonstrate that a significant portion of the reflection that results from exposing an energy sensitive resist material to radiation when the resist is applied directly over a topographic substrate is eliminated when the ARC of the present invention is interposed between the resist and the underlying topography.

## Claims

1. A process for device fabrication comprising:
forming an anti-reflection coating on a substrate with a non-planar surface;
forming a layer of an energy sensitive material over the anti-reflection coating wherein the interface of the anti-reflection coating and the energy sensitive material is denominated the top interface and the interface of the anti-reflection coating and the underlying substrate is denominated the bottom interface;
exposing the energy sensitive material to patterned radiation thereby introducing a pattern of the image into the energy sensitive material; and developing the pattern in the energy sensitive; wherein the anti-reflection coating is a silicon-containing oxide with a first index of refraction at the top interface between it and the energy-sensitive resist material and a second index of refraction in a plane between the the top interface and the bottom interface and wherein the first index of refraction is an index match with the index of refraction of the energy-sensitive resist material.

2. The process of claim 1 wherein the index of refraction of the anti-reflection coating is varied by varying the amount of silicon relative to the amount of oxygen in the anti-reflection coating.

3. The process of claim 2 wherein the index of refraction has two components, a real component and an imaginary components, and wherein each component of the second index of refraction is larger than its corresponding component in the first index of refraction.

4. The process of claim 3 wherein the anti-reflection coating has a plurality of layers, each layer having an index of refraction that is different from the index of refraction of the other layers.

5. The process of claim 4 wherein the thickness of the anti-reflection coating is sufficient to absorb substantially all of the radiation incident thereon when the energy-sensitive material is patternwise exposed to radiation.

6. The process of claim 5 wherein the real component of the index of refraction of each layer of the anti-reflection coating varies by an amount such that the amount of light reflected due to the index change is less than about 10 percent of the incident light.
